# EUROPÄISCHE PATENTSCHRIFT

(11) **EP 1 347 574 B1**
(45) Veröffentlichungstag und Bekanntmachung des Hinweises auf die Patenterteilung: **16.08.2006**
(21) Anmeldenummer: 02028309.9
(22) Anmeldetag: 17.12.2002
(51) Int. Cl.: H03H 17/06

(54) **Abtastratenumsetzer, insbesondere für asynchrone Eingang- und Ausgangssignale**
Sampling rate converter, in particular for asynchronous input and output signals
Convertisseur de la fréquence d'échantillonnage, notamment pour signaux d'entrée et de sortie asynchrones

(30) Priorität: 21.03.2002 DE 10212519
(43) Veröffentlichungstag der Anmeldung: 24.09.2003
(73) Patentinhaber: ROBERT BOSCH GMBH, 70442 Stuttgart (DE)
(72) Erfinder: Lehr, Carsten, 30451 Hannover (DE)

(56) Entgegenhaltungen:
- WO-A-99/56427
- US-A- 6 005 901
- US-A- 6 092 126
- PATENT ABSTRACTS OF JAPAN Bd. 1999, Nr. 09, 30. Juli 1999 (1999-07-30) -& JP 11 112440 A (MATSUSHITA ELECTRIC IND CO LTD), 23. April 1999 (1999-04-23)
- LAGADEC, R.; KUNZ, H.O.: "A universal, digital sampling frequency converter" IEEE INTERNATIONAL CONFERENCE ON ACOUSTICS, SPEECH, AND SIGNAL PROCESSING, ICASSP '81, Bd. 6, 30. März 1981 (1981-03-30), Seiten 595-598, XP002295978 ATLANTA, GA,USA
- CROCHIERE, R.E.; RABINER, L.R.: "Multirate digital signal processing" 1983, PRENTICE HALL INC. , ENGLEWOOD CLIFFS, NJ, USA , XP002296761 Seiten: 28-43, 78-87, 130-135, 174-179, 192-199 * Seiten 31,35,37 * * Seiten 131,132 * * Seiten 177,178 * * Seiten 193-199 *
- WILKINSON, B.: "Digital System Design" 1987, PRENTICE HALL INTERNATIONAL (UK) , LONDON , XP002296762 * Seite 69, Absatz 3 * * Seite 71; Abbildung 3.16 *
- TIETZE, U.; SCHENK, CH.: "Halbleiter-Schaltungstechnik" 1990, SPRINGER VERLAG , BERLIN, HEIDELBERG, DE , XP002296763 * Seite 285, Absatz 2 - Seite 287, Absatz 1; Abbildungen 11.19-11.21 *

## Beschreibung

Die Erfindung betrifft einen Abtastratenumsetzer, insbesondere für asynchrone Eingangs- und Ausgangssignale mit zeitlich veränderlicher Ausgangsabtastrate.

Unterschiedliche Signalquellen in digitalen Audiosystemen benutzen in der Regel unterschiedliche Abtastraten. So beträgt z. B. bei CD-Spielern die Abtastrate 44.1 kHz, bei FM/AM-Systemen z. B. 45,6 kHz, bei digitalem Audio-Broadcasting (DAB) 48 kHz. In einer Reihe von Anwendungen ist es jedoch wünschenswert, Signalquellen zu mischen, um z. B. Navigationsansagen oder Telefongespräche mit dem eigentlichen Audiosignal zu mischen oder Signale gleichzeitig verarbeiten zu können, um z. B. über Lautsprecher FM-Signale und über Kopfhörer CD-Signale hören zu können. Somit ist eine einheitliche Verarbeitung der Signale, z. B. Filterung oder Digital/Analog-Wandlung, erforderlich, für die die zu verarbeitenden Signale mit einer einheitlichen Abtastrate vorliegen müssen.

Die EP 0 401 562 B1 beschreibt einen derartigen Abtastratenumsetzer, bei dem die Abtastraten des Eingangs- und des Ausgangssignals in keinem bestimmten Zahlenverhältnis zueinander stehen müssen. Hierbei werden einem digitalen Filter Abtastwerte des Eingangssignals zugeführt, Koeffizienten des digitalen Filters in Abhängigkeit von dem Verhältnis der Abtastraten gebildet und Abtastwerte mit einem zweiten Abtasttakt aus dem digitalen Filter ausgelesen, wobei die Koeffizienten des digitalen Filters gemäß einer vorgegebenen Rechenvorschrift gebildet werden.

Herkömmliche Abtastratenumsetzer ermöglichen hierbei die Umsetzung in eine zeitlich feste Abtastrate. Somit wird bei dem Abtastratenumsetzer - z. B. in einem digitalen Filter - ein festes Verhältnis der Abtastraten vorgegeben, so dass die Abtastratenumsetzung ohne zeitliche Änderungen durchgeführt werden kann. Herkömmliche Audio-Abtastratenumsetzer sind in der Regel für Signal-Rausch-Abstände bis 96 dB und Signalbandbreiten bis 20 kHz, wie z. B. für CD erforderlich, ausgelegt. Sie arbeiten mit einer Eingangsabtastrate bzw. Quellenabtastrate, die ebenso wie die Ausgangsabtastrate bzw. Zielabtastrate im Bereich von 44.1 kHz bis 48 kHz liegt.

In PATENT ABSTRACT OF JAPAN Bd. 1999, Nr. 09,30. Juli 1999 (1999-07-30) -& JP 11 112440 A, 23. April 1999 (1999-04-23) wird ein Abtastratenumsetzer zur Umsetzung eines Eingangssignals mit einer Eingangsabtastrate in ein Ausgangssignal mit einer Ausgangsabtastrate gezeigt, der eine Einrichtung zum Ermitteln eines AbtastratenVerhältnisses aufweist, die Abtastraten-Verhältnis-Daten aus ermittelten Abtastraten eines Eingangssignals und eines Ausgangssignals an eine Korrektureinrichtung ausgibt. Eine arithmetische Einrichtung transformiert die Abtastrate eines Eingangs auf Basis von Frequenzverhältnis-Daten; die durch die Korrektureinrichtung korrigiert sind. Ein FIFO nimmt das Ausgangssignal der arithmetischen Einrichtung auf, um es mit einem Taktgeber für das Ausgangssignal zu synchronisieren, wobei eine Grenzwertermittlungseinrichtung von dem FIFO angesteuert wird, um eine Korrekturdaten-erzeugende Einrichtung zur Ausgabe von Grenzwertdaten anzusteuern. Die Korrekturdaten-erzeugende Einrichtung erzeugt Korrekturdaten auf Basis des Wertes der Grenzwertdaten. Die Korrektureinrichtung addiert die Frequenzverhältnis-Daten und Korrekturdaten und gibt korrigierte Frequenzverhältnis-Daten aus.

In LAGADEC, R.; KUNZ, H.O.: " A universal, digital sampling frequency converter" IEEE INTERNATIONAL CONFERENCE ON ACOUSTICS, SPEECH, AND SIGNAL PROCESSING, ICASSP '81, Bd. 6, 30. März 1981 (1981-03-30), Seiten 595-598, XP002295978 ATLANTA, GA, USA, wird ein Abtastratenumsetzer gemäß dem Oberbegriff von Anspruch beschrieben. Eine derartige Vorrichtung wird hierbei Umkehrung durch der Struktur einer Vorrichtung zur Abtastraten erhöhung hergeleitet.

Der erfindungsgemäße Abtastratenumwandler nach Anspruch 1 weist gegenüber bekannten Abtastratenumwandlern insbesondere den Vorteil auf, dass er mit relativ geringem Aufwand, insbesondere flächensparend und kostengünstig, herstellbar ist und eine Umsetzung in eine zeitlich variable Abtastrate des Ausgangssignals ermöglicht. Hierbei wird vorteilhafterweise eine Umsetzung in einem großen Bereich des Abtastratenverhältnisses, bei dem die Eingangsabtastrate deutlich größer als die Ausgangsabtastrate sein kann, ermöglicht. Erfindungsgemäß können z.B. Signale im Frequenzbereich zwischen 0.04 kHz und 15 kHz mit einem Signal-Rauschabstand von 70 dB umgesetzt werden.

Erfindungsgemäß wird hierbei eine Anpassung an den zeitlich veränderlichen Ausgangstakt durch den Zwischenspeicher ermöglicht, der z. B. als FIFO ausgelegt sein kann, und dessen Füllstand als Füllstandssignal der Steuereinrichtung mitgeteilt wird. Erfindungsgemäß wird aus dem Eingangssignal mit Eingangstakt bzw. Eingangsabtastrate zunächst durch geeignete Interpolation ein Signal mit einer Mittelungsabtastrate gebildet, die ein zeitliches Mittel der zeitlich variablen Ausgangsabtastrate darstellt. Diese Mittelungsabtastrate wird hierbei weiterhin als Stellgröße zur Regelung des Füllstandes des Zwischenspeichers verwendet, der ein Füllstandssignal an die Steuereinrichtung ausgibt, die das Umsetzungsverhältnis in einer zweiten Interpolationseinrichtung jeweils anpasst.

Die erfindungsgemäße Steuereinrichtung kann insbesondere mit wenigen Multiplizierern oder ohne Multiplizierer realisiert werden, indem eine an das jeweilige Signal angepasste, ausreichend große Bitbreite verwendet wird. Hierdurch kann der Hardwareaufwand vorteilhafterweise gering gehalten werden. Hierzu kann ein die mittlere Taktlänge beschreibendes Signal in geeigneter Weise skaliert werden, so dass die Taktlänge des Ausgangsabtasttaktes bei Darstellung in einer Steuerbitbreite B einfach dargestellt werden kann, z. B. als 2exp(B-2). Der Taktjitter kann durch geeignete Wahl der Abtastzeitpunkte für die z. B. quadratische Interpolation ebenfalls gering gehalten werden.

Bei der Berechnung der Abweichung des Füllstandes des Zwischenspeichers kann die Auflösung erhöht werden, indem berücksichtigt wird, in welcher Taktperiode des vielfachen Eingangstaktes relativ zu dem Eingangstakt ein Wert aus dem Zwischenspeicher ausgelesen wird. Die Festlegung der Gewichtung der Füllstandsabweichung des Zwischenspeichers kann insbesondere über eine vom Füllstand abhängige, parametrierbare Kennlinie erfolgen. Der Betriebszustand des Zwischenspeichers kann über ein Hilfssignal berechnet und angezeigt werden.

Die Erfindung wird im folgenden anhand der beiliegenden Zeichnungen an einer Ausführungsform erläutert. Es zeigen:
- Fig. 1: ein Blockdiagramm eines erfindungsgemäßen Abtastratenumsetzers;
- Fig. 2: ein Blockdiagramm eines Aufbaus einer quadratischen Interpolationseinrichtung aus Fig. 1;
- Fig. 3: ein Blockdiagramm eines Aufbaus einer Steuereinrichtung aus Fig. 1;
- Fig. 4: ein Zeitdiagramm mit Abtastzeitpunkten eines Eingangs- und Ausgangssignals aus Fig. 1;
- Fig. 5: ein Blockdiagramm einer Taktskalierungseinrichtung aus Fig. 3;
- Fig. 6: ein Blockdiagramm einer Füllstandsskalierungseinrichtung aus Fig. 3;
- Fig. 7: ein Blockdiagramm von Tiefpassfiltereinrichtungen aus Fig. 3;
- Fig. 8: ein Blockdiagramm einer Gewichtungsberechnungseinrichtung aus Fig. 3;
- Fig. 9: eine Kennlinie der Gewichtungsberechnungseinrichtung aus Fig. 8;
- Fig. 10: ein Blockdiagramm einer Steuersignalberechnungseinrichtung aus Fig. 3.

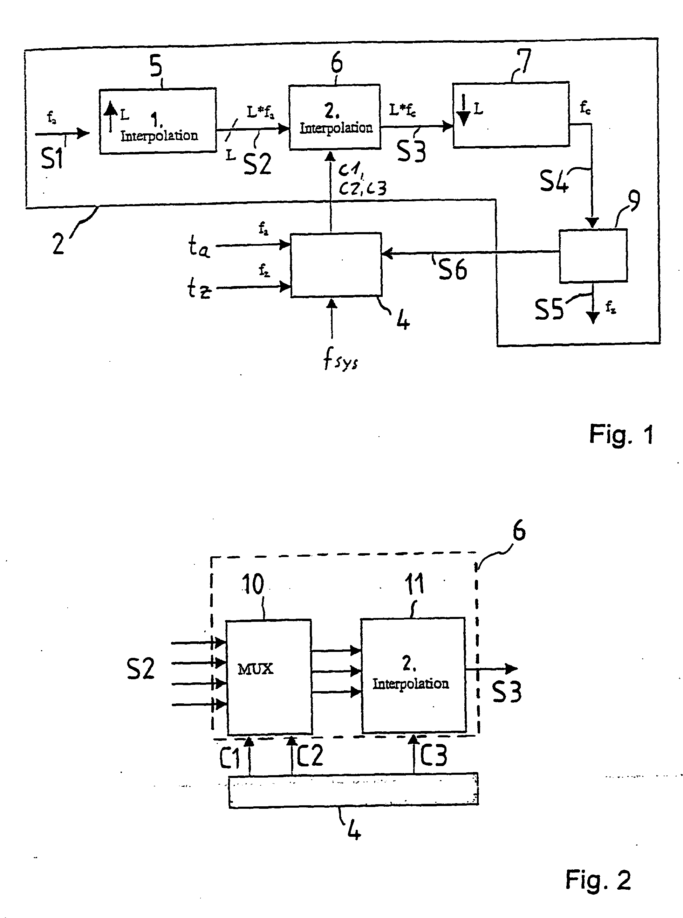

Ein Abtastratenumsetzer weist gemäß Fig. 1 einen Datenpfad 2 und eine Steuereinrichtung 4 auf. In den Datenpfad 2 wird ein Eingangssignal s1 mit einer Eingangsabtastrate fa eingegeben und ein Ausgangssignal s5 mit einer zeitlich variablen Ausgangsabtastrate fz ausgegeben. Der Steuereinrichtung 4 wird ein Eingangstaktsignal ta mit der Eingangsabtastrate fa und ein Ausgangstaktsignal tz mit der Ausgangsabtastrate fz eingegeben; die Abtastrate bzw. Frequenz fsys des Systemtaktes ist im allgemeinen unabhängig von fa und fz.

Der Datenpfad ist an die geforderte Leistungsfähigkeit des Abtastratenumsetzers angepasst mit z. B. einer Datenbitbreite von 16 Bit.

Das Eingangssignal s1 wird in dem Datenpfad 2 zunächst in einer ersten Interpolationseinrichtung 5 um den Faktor L auf die Abtastrate L * fₐ erhöht. Das so gebildete zweite Signal s2 mit der Abtastrate L * fₐ wird in einer zweiten Interpolationseinrichtung 6, die als quadratische Interpolationseinrichtung ausgebildet ist, in Abhängigkeit von Steuersignalen c1, c2, c3 der Steuereinrichtung 4 in ein drittes Signal s3 mit einer L-fachen Mittelungsabtastrate fc umgesetzt. In einer Dezimationseinrichtung 7 wird das dritte Signal s3 um den Faktor L dezimiert und das vierte Signal s4 mit der Mittelungsabtastrate fc ausgegeben. Das vierte Signal s4 wird in einen als FIFO ausgebildeten Zwischenspeicher 9 eingegeben und aus diesem als Ausgangsignal s5 mit der zeitlich variablen Ausgangsabtastrate f_{z} ausgelesen. Der Zwischenspeicher 9 gibt weiterhin ein Füllstandssignal s6 an die Steuereinrichtung 4 aus, das den Füllstand bzw. Füllungsgrad des Zwischenspeichers 9 anzeigt.

Die Steuerung des Abtastratenumsetzers erfolgt über die Steuereinrichtung 4, die den Füllungsgrad des Zwischenspeichers durch Einstellung der Mittelungsabtastrate f_{c} in der zweiten Interpolationseinrichtung 6 regelt. Durch den Zwischenspeicher 9 und die Regelung über die Steuereinrichtung können somit Schwankungen des Ausgangstaktes bzw. Zieltaktes ausgeglichen werden, wobei aufgrund der Regelung ein relativ kleiner Zwischenspeicher 9 erforderlich ist. Hierdurch wird insbesondere der Einfluss des Jitters des Ausgangstaktes auf die Leistungsfähigkeit des Abtastratenumsetzers reduziert. Das vierte Signal s4 mit der Mittelungsabtastrate f_{c} dient somit als Hilfssignal zur geeigneten Anpassung des Eingangssignals s1 mit der Eingangsabtastrate fₐ an das Ausgangssignal s5 mit zeitlich variabler Ausgangsabtastrate f_{z.} Die Mittelungsabtastrate f_{c} dient hierbei insbesondere auch der vorteilhaften Ausbildung der quadratischen Interpolationseinrichtung 6, da erfindungsgemäß die Abtastzeitpunkte für die quadratische Interpolation durch f_{c} bestimmt werden und nicht durch die zeitlich variable Ausgangsabtastrate f_{z}. Der Faktor L kann z. B. als L = 4 gewählt werden; je größer er gewählt wird, desto besser ist im allgemeinen die mit dem Abtastratenumsetzer erreichbare Performance bzw. Leistungsfähigkeit, wobei jedoch der Hardwareaufwand der Realisierung mit L ebenfalls steigt.

In der ersten Interpolationseinrichtung 5 erfolgt eine Erhöhung der Abtastrate fₐ um den Faktor L durch eine Überabtastung des Eingangssignals s1 und eine nachfolgende Tiefpassfilterung. Die Überabtastung erfolgt durch Einfügen von Nullen, wobei zwischen zwei Eingangswerte des Eingangssignals s1 jeweils L - 1 Nullen eingefügt werden. Die Tiefpassfilterung erfolgt mit einem FIR-Filter. Hierbei kann ein ein- oder mehrstufiger Aufbau realisiert werden. Für L = 4 kann z. B. ein zweistufiger Aufbau mit L1 * L2 = L und L1 = L2 = 2 gewählt werden, so dass in der ersten Stufe die Eingangsabtastrate fₐ durch Einfügen von L1 - 1 Nullen und Tiefpassfilterung auf L1 * fₐ erhöht wird, und in der nachfolgenden zweiten Stufe wiederum durch Einfügen von L2 - 1 Nullen und Tiefpassfilterung auf L * fₐ erhöht wird. Hierbei können beide Tiefpassfilter als FIR-Filter realisiert sein. Bei Verwendung für ein FM-Audiosignal hat das Tiefpassfilter der ersten Stufe entsprechend der Bandbreite einen Durchlassbereich bis ≥ 15 kHz und eine Sperrbereich ab 228 kHz/2 - 15 kHz = 99 kHz mit einer Sperrdämpfung von 80 dB. Ausgegangen wird hier z. B. von einem Eingangstakt fₐ = 228 kHz. Das Tiefpassfilter der zweiten Stufe hat einen Durchlassbereich von mindestens 15 kHz und einen Sperrbereich ab 375 kHz mit einer Sperrdämpfung von ebenfalls 80 dB. Das Tiefpassfilter der zweiten Stufe ist als Halbbandfilter realisiert. Beide Filter haben symmetrische Koeffizienten, um eine einfache Hardwarerealisierung mit einer minimalen Anzahl an Multiplikationen zu ermöglichen.

In der quadratischen Interpolationseinrichtung 6 wird für jeden durch den Takt L * f_{c} festgelegten Abtastzeitpunkt ein neuer Abtastwert berechnet. Dazu wird zwischen den drei den Abtastzeitpunkten am nächsten liegenden Werten des zweiten Signals s2 quadratisch auf die Abtastwerte des dritten Signals as mit des vielfachen Mittelungsabtastrate (L * fc) interpoliert. Hierzu weist die quadratische Interpolationseinrichtung 6 gemäß Fig. 2 eine quadratische Interpolationseinheit 11 und einen Multiplexer 10 auf, der aus jeweils L von der ersten Interpolationseinrichtung 5 in einem Taktintervall fa zur Verfügung gestellten Werten jeweils drei Abtastwerte auswählt. Die quadratische Interpolation wird durch die Steuereinrichtung 4 gesteuert. Die Steuereinrichtung 4 berechnet hierbei, ob in einem Taktintervall fa ein Abtastwert im Takt L * f_{c} zu berechnen ist, was durch ein erstes Steuersignal c1 angezeigt wird, ggf. die Auswahl der drei Datenwerte für die Interpolation, was durch ein zweites Steuersignal c2 angezeigt wird, und die für die Interpolation benötigte Position des Abtastzeitpunktes des Taktes bzw. der Abtastrate L * fc relativ zu den Abtastzeitpunkten der drei Datenwerte, was durch ein drittes Steuersignal c3 festgelegt wird. Hierbei wird vorausgesetzt, dass fa > L* fc ist.

Die Dezimationseinrichtung 7 reduziert die Abtastrate L * f_{c} des dritten Signals s3 um den Faktor L durch Tiefpassfilterung mit nachfolgender Unterabtastung. Die Tiefpassfilterung erfolgt mit einem FIR-Filter. In Verbindung mit der Unterabtastung um den Faktor L wird das Tiefpassfilter als Polyphasenfilter ausgeführt, d. h., dass nur diejenigen Werte berechnet werden, die nach der Unterabtastung auch tatsächlich benötigt werden. Das Tiefpassfilter ist hierbei derartig ausgelegt, dass für den gesamten Ausgangsfrequenzbereich bzw. Zielfrequenzbereich von 44.1 kHz bis 48 kHz nur ein Koeffizientensatz benötigt wird. Entsprechend der Bandbreite des FM-Audiosignals hat das Tiefpassfilter einen Durchlassbereich bis 15 kHz und einen Sperrbereich ab 24 kHz für f_{z} = 44.1 kHz bzw. ab 26.5 kHz für f_{z} = 48 kHz. Die Sperrdämpfung beträgt mindestens 72 dB.

Der Zwischenspeicher bzw. FIFO 9 ist ein Schieberegister der Länge K, in das Abtastwerte mit der Mittelungsabtastrate f_{c} geschrieben und mit der Ausgangsabtastrate f_{z} ausgelesen werden. Ziel der Steuerung des Abtastratenumsetzers ist es, die Mittelungsabtastrate f_{c} so nachzuführen, dass das Schieberegister im Mittel halb gefüllt ist, um Taktschwankungen von f_{z} ausgleichen zu können, ohne dass ein Überlauf oder Leerlauf (Unterlauf) des Schieberegisters 9 auftreten. Hierbei kann z. B. ein Schieberegister der Größe K = 32 verwendet werden. Bei dem Schieberegister 9 kann eine Überlauf-/Unterlauferkennung realisiert werden, um das Verhalten des Abtastratenumsetzers im Fehlerfall, z. B. bei einer zu kleinen oder zu großen Zielabtastrate, kontrollieren zu können. Im Fall eines Überlaufs, bei dem das Schieberegister voll ist, wird beim Schreiben eines neuen Wertes gleichzeitig mit dem Schreibzeiger auch der Lesezeiger des FIFOs 9 inkrementiert, der Füllstand des FIFOs bleibt unverändert. Im Falle eines Unterlaufs, d. h., wenn das Schieberegister leer ist, wird statt eines berechneten Abtastwertes eine Null ausgegeben und der Lesezeiger des FIFOs 9 nicht verändert.

Die Steuereinrichtung 4 dient dazu, die Abtastzeitpunkte für die quadratische Interpolation in der quadratischen Interpolationseinrichtung 6 aus der Ausgangsabtastrate f_{z} so zu bestimmen, dass der Einfluss des Taktjitters reduziert wird. Zugleich wird vorteilhafterweise der Füllstand des FIFOs 9 berücksichtigt, um einem Über- oder Unterlauf des FIFOs rechtzeitig entgegen wirken zu können.

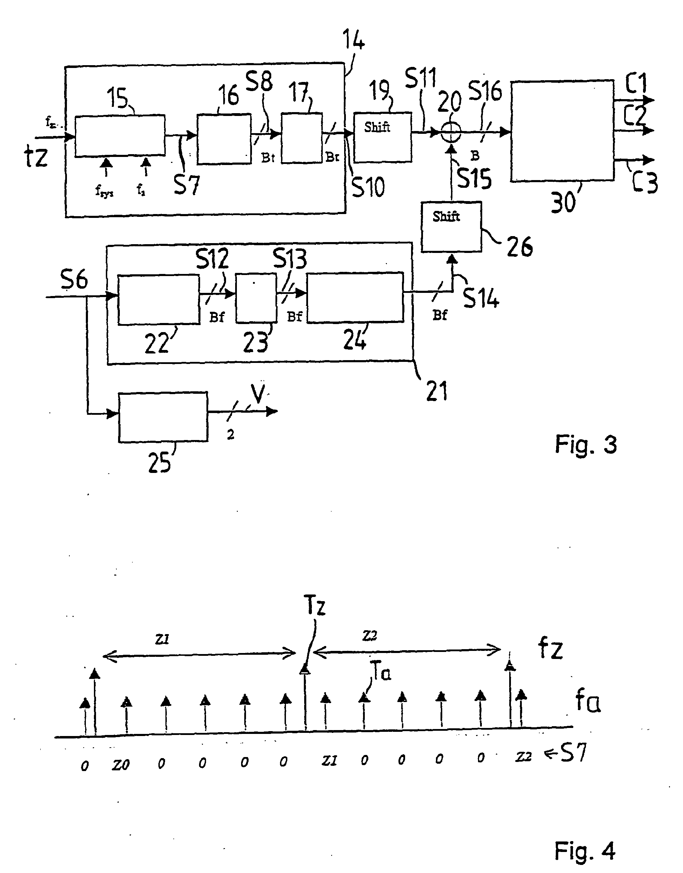

Gemäß Fig. 3 weist die Steuereinrichtung 4 eine Einrichtung 14 zur Ermittlung einer mittleren Taktlänge auf, die das die Ausgangsabtastrate fz anzeigende Ausgangstaktsignal tz aufnimmt und ein mittleres Taktlängensignals 10 ausgibt, das über eine Shifteinrichtung 19 als Signal s11 einem Addierer 20 zugeführt wird. Weiterhin wird das Füllstandssignal s6 einer Korrekturermittlungseinrichtung 21 zugeführt, die ein Korrektursignal s14 an eine Shifteinrichtung 26 ausgibt, die ein Signal s15 dem Addierer 20 zuführt. Das von dem Addierer 20 ausgegebene Zwischensignal s16 wird in einer Steuersignalberechnungseinrichtung 30 für die quadratische Interpolation in die Steuersignale c1, c2, c3 umgewandelt.

In der Steuereinrichtung 4 wird somit aus der Ausgangsabtastrate fz in der Einrichtung 14 eine mittlere Taktlänge ermittelt, die grundsätzlich bereits als Mittelungsabtastrate fc gewählt werden könnte. Um den Füllstand des FIFO 9 zu berücksichtigen, wird in der Korrekturermittlungseinrichtung 21 - wie unten detaillierter erläutert wird - zunächst eine mittlere Abweichung des Füllstandes des FIFOs 9 ermittelt, skaliert und über den Addierer 20 zur mittleren Taktlänge hinzu addiert, so dass die Mittelungsabtastrate in Abhängigkeit vom Füllstand des FIFOs geändert wird derartig, dass bei einem vollen FIFO die mittlere Taktlänge erhöht wird, um eine langsamere Berechnung neuer Werte zu erreichen, und bei einem leeren FIFO die Berechnung entsprechend beschleunigt wird.

In der unten weiter beschriebenen Auswertelogikeinrichtung 25 wird ein Anzeigesignal (v) ermittelt, das den Betriebszustand des Abtastratenumsetzers anzeigt.

In der Einrichtung 14 zur Ermittlung der mittleren Taktlänge wird in einem Hardwarezähler 15 zunächst, wie in Fig. 4 gezeigt, mit Hilfe des Systemtaktes fsys eine Länge Z1, Z2 der Taktperioden zwischen zwei Abtastzeitpunkten Tz des Ausgangssignals s5 mit der Ausgangsabtastrate fz ermittelt. Der Hardwarezähler 15 gibt im Takt fa das Signal S7 mit Werten Zi und Nullen zu Eingangsabtastzeitpunkten Ta aus. Es gilt hierbei immer fz < fa. In den Takten fa, in denen ein Abtastzeitpunkt Tz des Ausgangstaktes fz liegt, wird die Länge der aktuellen Taktperiode des Ausgangstaktes fz bezogen auf die Taktlänge des Systemtaktes fsys ausgegeben. In den übrigen Takten, in die kein Abtastzeitpunkt des Ausgangstaktes fällt, wird der Wert Null ausgegeben.

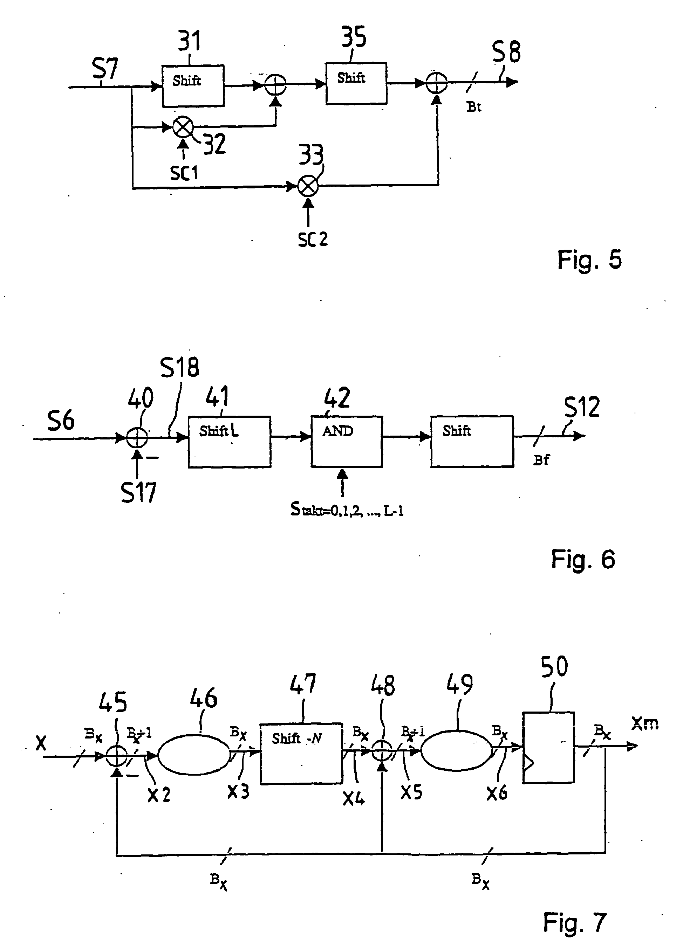

In der Taktskalierungseinrichtung 16 wird das Hardwarezählersignal s7 mit einem programmierbaren Skalierungsfaktor sc gewichtet, was durch Addition zweier Skalierungswerte sc1, sc2 nach Shiftoperationen erfolgt. In Fig. 5 ist eine Realisierung der Taktskalierungseinrichtung 16 mit zwei Shifteinrichtungen 31, 35 gezeigt, deren Ausgang jeweils mit den Produktsignalen von s7 mit Skalierungswerten sc1, sc2 addiert werden. Somit wird eine Realisierung mit lediglich zwei Multiplikationen 32, 33 erreicht. Hierdurch wird eine einfache Anpassung an unterschiedliche Eingangsabtastraten fa möglich. Die Skalierung wird nur berechnet, wenn s7 < 0 ist. Der Skalierungsfaktor wird so gewählt, dass nach der Skalierung die Taktperiode des Eingangstaktes bzw. der Eingangsabtastrate fa bei Darstellung mit einer Steuerbitbreite B dem Wert 2exp(B-2) bzw. 2(B-2) entspricht, wobei B durch die Steuersignalberechnungseinrichtung 30 vorgegeben ist, wie weiter unten beschrieben wird; hierbei kann z. B. B = 24 sein. Am Ausgang der Taktskalierungseinrichtung 16 wird ein skaliertes Hardwarezählersignal s8 mit einer Bitbreite Bt, z. B. Bt = 32, ausgegeben.

Die in Fig. 3 gezeigte Korrekturermittlungseinrichtung 21 weist eine Füllstandsskalierungseinrichtung 22 auf, die das Füllstandssignal s6 aufnimmt und ein skaliertes Füllstandssignal s12 einer Bitbreite Bf von z. B. Bf = 24 an einen Tiefpass 23 ausgibt. Der Tiefpass 23 liefert mit dem tiefpassgefilterten skalierten Füllstandssignal s13 bereits einen Wert der mittleren Abweichung des Füllstandes des FIFOs 9 vom Soll-Wert. Diese mittlere Abweichung wird in einer Gewichtungsberechnungseinrichtung 24 skaliert, wodurch das Korrektursignal s14 ausgegeben wird.

Gemäß Fig. 6 weist die Füllstandsskalierungseinrichtung 22 einen Addierer 40 auf, bei dem vom Füllstandssignal s6 ein Soll-Füllstandssignal s17 mit dem Soll-Füllstandswert des FIFOs 9 abgezogen wird und ein die Füllstandsdifferenz anzeigendes Hilfssignal s18 über eine Shifteinrichtung 41 mit dem Faktor 2^{L} skaliert, ein Signaltakts s-takt in einer AND-Einrichtung 42 addiert wird, um die Auflösung der berechneten Füllstandsabweichung zu verbessern. Das Signal s-Takt gibt an, in welcher Taktperiode L * fₐ relativ zum Takt fₐ der Werte aus dem FIFO 9 ausgelesen wurde. Anschließend erfolgt durch eine weitere Shiftoperation die Skalierung auf die gewünschte Bitbreite Bf = 24, und das skalierte Füllstandssignal s12 wird an zweiten Tiefpass 23 ausgegeben.

Die beiden Tiefpässe 17, 23 der Fig. 3 können erfindungsgemäß ohne Multiplizierer ausgebildet werden. Gemäß Fig. 7 wird hierzu eine Tiefpassstruktur geschaffen, bei der Shiftoperationen zur Einstellung der Zeitkonstanten des Tiefpasses verwendet werden und aus einem Eingabesignal x mit einer Bitbreite Bx ein Ausgabesignal xm erzeugt wird. Hierbei ist Bx an die für das jeweilige Signal x benötigte Genauigkeit angepasst. In der gewählten Ausführungsform ist eine Bitbreite von Bx = Bt = 32 gewählt; für die Tiefpassfilterung des FIFO-Füllstandssignals wird eine Bitbreite von Bx = Bf = 24 gewählt. Gemäß Fig. 7 wird in dem Tiefpass von dem Eingabesignal x in einem Addierer 45 das Ausgabesignal xm subtrahiert, das hierdurch erzeugte, in seiner Bitbreite inkrementierten Signal x2 in einer Clipping-Einrichtung 46 wieder um ein Bit reduziert, das hierdurch erzeugte Signal x3 in einer Shift-Einrichtung 47 mit dem Faktor 2exp(-N) skaliert in das Signal x4 und in einem weiteren Addierer 48 mit dem Ausgabesignal xm addiert, das erzeugte Signal x5 anschließend wieder in einer Clipping-Einrichtung 49 um ein Bit reduziert. Das so gebildete Signal x6 wird in das Register 50 eingelesen und das Ausgabesignal xm ausgelesen.

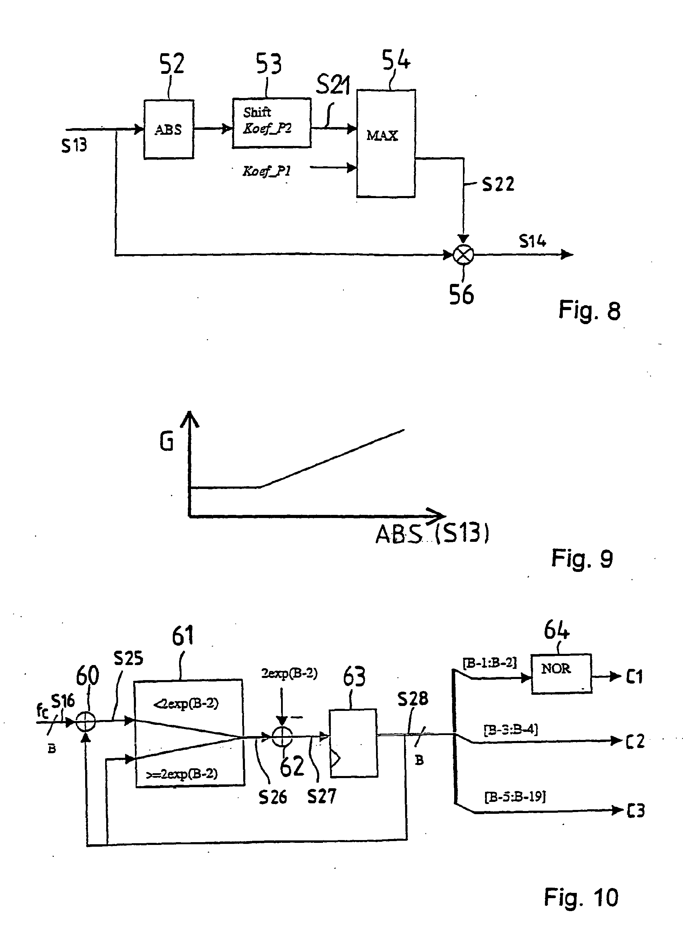

Der Aufbau der in Fig. 3 gezeigten Gewichtungsberechnung 24 ist in Fig. 8 gezeigt. Durch diesen Aufbau wird die in Fig. 9 gezeigte Kennlinie eingestellt. Die Kennlinie zeigt den Gewichtungsfaktor G in Abhängigkeit von dem Betrag der Füllstandsabweichung gemäß dem Signal s13. Bis zu einem Grenzwert bzw. Abknickwert der Kennlinie ergibt sich ein konstanter Gewichtungsfaktor, für höhere Werte erfolgt eine lineare Erhöhung. Somit kann für größere Füllstandsabweichungen eine schnellere Anpassung der Mittlungsabtastrate f_{c} erfolgen als bei kleiner Füllstandsabweichung. Hierdurch kann einem Über- oder Unterlauf des FIFOs 9 besser entgegen gewirkt werden.

Hierzu wird in der Gewichtungsberechnungseinrichtung 24 gemäß Fig. 8 zunächst in der Einrichtung 52 ein Absolutwert gebildet, anschließend über die Shifteinrichtung 53 mit dem Koeffizienten Koef-P2 eine Skalierung, d. h. um den Faktor 2exp(Koef-p2), erreicht, und das so gebildete Signal s21 zusammen mit einem Signal Koef-P1 einer maximalwertbildenden Einrichtung 54 zugeführt. Das von der maximalwertbildenden Einrichtung 54 ausgegebene Maximalwertsignal s 22 wird zusammen mit dem Signal s13 einem Multiplizierer 56 eingegeben, der das Signal s14 bildet.

Die Steuersignalberechnungseinrichtung 30 für die quadratische Interpolation ist gemäß Fig. 10 aufgebaut. Das Signal s16 mit der Bitbreite B und dem Takt fc wird einem Addierer 60 zugeführt und mit einem Gesamtsteuersignal s28 addiert, wodurch ein Signal s25 gebildet wird. Gemäß der Vergleichseinrichtung 61 wird ermittelt, ob s25 kleiner als der Wert 2exp(B-2) ist (erster Fall) oder nicht (zweiter Fall). Im ersten Fall wird das Signal s25 einem Addierer 62 zugeführt, im zweiten Fall das Gesamtsteuersignal s28. In dem Addierer 62 wird der Wert 2exp (B-2) subtrahiert und das so gebildete Signal s27 einem Register 63 zugeführt, aus dem das Gesamtsteuersignal s28 mit der Bitbreite B ausgelesen wird. Die beiden oberen Bits [B-1: B-2] des Gesamtsteuersignals s28 werden über ein NOR-Gatter 64 geführt und als erstes Steuersignal c 1 verwendet, das - wie bereits mit Bezug zu Fig. 2 beschrieben wurde - anzeigt, ob eine Interpolation durchzuführen ist. Falls dies der Fall ist, geben die als zweites Steuersignal c2 verwendeten nächsten beiden Bits [B-3: B-4] an, welche drei der vier Eingangswerte für die quadratische Interpolation verwendet werden. Die weiteren Bits [B-5: B-19] geben als das dritte Steuersignal c3 die Lage des Abtastzeitpunktes relativ zu den Abtastzeitpunkten der Datenwerte an.

In der Auswertelogikeinrichtung 25 der Fig. 3 wird aus dem Füllstandssignal s6 ein Kontrollsignal v erzeugt, das den aktuellen Betriebszustand des Abtastratenumsetzers angibt. Das Kontrollsignal v wird hierbei so berechnet, dass der Betriebszustand "Unterlauf" angezeigt wird, wenn der Füllzustand des FIFOs ≤ G1 ist, und der Betriebszustand "Überlauf" angezeigt wird, wenn der Füllzustand ≥ G2 ist.

Tritt ein Überlauf des FIFOs 9 aufgrund einer zu niedrigen Ausgangsabtastrate f_{z} auf, so ist ein ständiger Wechsel des FIFO-Füllstandes zwischen den Werten K und K - 1 zu beobachten. Tritt ein Unterlauf des FIFOs aufgrund einer zu hohen Ausgangsabtastrate f_{z} auf, so ist ein ständiger Wechsel des FIFO-Füllstandes zwischen den Werten 0 und 1 zu beobachten. Aus diesem Grund wird in dieser Ausführungsform G1 = 1 und G2 = K - 1 gewählt. Damit wird erreicht, dass ein Überlauf bzw. ein Unterlauf des FIFOs zuverlässig erkannt wird.

Zusätzlich wird im Signal v angezeigt, ob ein zulässiger Ausgangstakt bzw. eine zulässige Ausgangsabtastrate f_{z} anliegt. Eine fehlende oder zu langsame Ausgangsabtastrate f_{z} wird angezeigt, wenn für mehr als TvTaktperioden der Eingangsabtastrate kein Taktsignal des Ausgangstaktes bzw. der Ausgangsabtastrate f_{z} erkannt wird. Der Wert Tv ist programmierbar, um eine Anpassung an verschiedene Eingangs- und Ausgangsabtastraten zu ermöglichen.

In dem in Fig. 3 gezeigten Aufbau der Steuereinrichtung 4 werden lediglich in der Taktskalierungseinrichtung 16, der Gewichtungsberechnungseinrichtung 24 Multiplikationen benötigt.

## Patentansprüche

1. Abtastratenumsetzer zur Umsetzung eines Eingangssignals (s1) mit einer Eingangsabtastrate (fₐ) in ein Ausgangssignal (s5) mit einer Ausgangsabtastrate (f_{z}), insbesondere für asynchrone Eingangs- und Ausgangssignale mit zeitlich veränderlicher Ausgangsabtastrate, wobei der Abtastratenumsetzer aufweist:
eine erste Interpolationseinrichtung (5), die das Eingangssignal (s1) aufnimmt, eine erste Interpolation durchführt und ein zweites Signal (s2), dessen Abtastrate (L * fa) ein Produkt aus der Eingangsabtastrate (fa) und einem ersten Faktor (L) ist, ausgibt,
eine zweite Interpolationseinrichtung (6), die das zweite Signal (s2) aufnimmt, eine zweite Interpolation durchführt und ein drittes Signal (s3) ausgibt,
eine Dezimationseinrichtung (7), die das dritte Signal (s3) aufnimmt, eine Dezimation durchführt und ein viertes Signal (s4) mit der Mittelungsabtastrate (f_{c}) ausgibt
**dadurch gekennzeichnet, dass**
die zweite Interpolationseinrichtung (6) die zweite Interpolation in Abhängigkeit von mindestens einem Steuersignal (c 1,2,3) durchführt,
das dritte Signal (s3) eine vielfache Mittelungsabtastrate (L * fc) aufweist, die ein Produkt aus einer Mittelungsabtastrate (fc) und dem ersten Faktor (L) ist,
die Dezimationseinrichtung (7) eine Dezimation um den ersten faktor (L) durchführt,
eine Steuereinrichtung (4) vorgesehen ist, die ein Eingangsfrequenzsignal (ta) und ein Ausgangsfrequenzsignal (t_{z}) aufnimmt, die Mittelungsabtastrate (fc) ermittelt und das mindestens eine Steuersignal (c 1,2,3) zur Einstellung der zweiten Interpolation an die zweite Interpolationseinrichtung (6) ausgibt,
ein Zwischenspeicher (9) vorgesehen ist, der das vierte Signal (s4) aufnimmt und aus dem das Ausgangssignal (s5) mit der Ausgangsabtastrate (fz) ausgelesen wird,
wobei der Zwischenspeicher (9) in Abhängigkeit von seinem Füllungsgrad ein Füllstandssignal (s6) an die Steuereinrichtung (4) ausgibt und die Steuereinrichtung (4) den Füllungsgrad des Zwischenspeichers (9) durch Veränderung der Mittellungsabtastrate (fc) regelt,
wobei die Steuereinrichtung (4) aufweist
eine Einrichtung (14) zur Ermittlung einer mittleren Taktlänge, die das Ausgangsfrequenzsignal (tz) aufnimmt und ein mittleres Taktlängensignal (s10) ausgibt, eine Einrichtung (21) zum Ermitteln eines Korrekturanteils, die das Füllstandssignal (s6) aufnimmt und ein Korrektursignal (s14) ausgibt, und
eine Steuersignalberechnungseinrichtung (30), die in Abhängigkeit von dem mittleren Taktlängensignal (s10) und dem Korrektursignal (s14) das mindestens eine Steuersignal (c 1,2,3) ermittelt,
wobei die Einrichtung (21) zum Ermitteln eines Korrekturanteils aufweist eine Füllstandsskalierungseinrichtung (22) die das Füllstandssignal (s6) aufnimmt und ein skaliertes Füllstandssignal (s12) ausgibt, Herste eine Tiefpasseinrichtung (23), die das skalierte Füllstandssignal (s12) tiefpassfiltert und ein tiefpassgefiltertes skaliertes Füllstandssignal (s13) ausgibt und eine Gewichtungsberechnungseinrichtung (24), die
das tiefpassgefilterte skalierte Füllstandssignal (s13) aufnimmt, gewichtet und das Korrektursignal (s14) ausgibt.

2. Abtastratenumsetzer nach Anspruch 1, **dadurch gekennzeichnet, dass** der erste faktor (L) ganzzahlig ist.

3. Abtastratenumsetzer nach Anspruch 2, **dadurch gekennzeichnet, dass** die erste Interpolationseinrichtung (5) eine oder mehrere aufeinanderfolgende Interpolationsstufen aufweist, in denen jeweils eine Überabtastung des Eingangssignals (s1) durch Einfügen ganzzahliger Anzahlen von Nullen zwischen zwei Eingangswerten und eine anschließende Tiefpassfilterung durchgeführt wird.

4. Abtastratenumsetzer nach Anspruch 3, **dadurch gekennzeichnet, dass** die Tiefpassfilter der Interpolationsstufen der ersten Interpolationseinrichtung (5) FIR-Filter, vorzugsweise mit symmetrischen Koeffizienten, sind.

5. Abtastratenumsetzer nach einem der vorherigen Ansprüche, **dadurch gekennzeichnet, dass** die Dezimationseinrichtung (7) das dritte Signal (s3) tiefpassfiltert und nachfolgend unterabtastet, vorzugsweise mittels eines Polyphasenfilters, das die für die Unterabtastung erforderlichen Abtastwerter der vierten Signals (s4) mit der Mittelungsabtastratedes vierten siganls (s4) mit (fc) ermittelt.

6. Abtastratenumsetzer nach einem der vorherigen Ansprüche, **dadurch gekennzeichnet, dass** die zweite Interpolationseinrichtung (6) eine nichtlineare, vorzugsweise quadratische Interpolation mit den Abtastwerten des zweiten Signals (s2) in Abhängigkeit von dem Steuersignal (c 1,2,3) durchführt.

7. Abtastratenumsetzer nach Anspruch 6, **dadurch gekennzeichnet, dass** die zweite Interpolationseinrichtung (6) die Abtastwerte des dritten Signals (s3) ermittelt, indem sie zwischen einer vorgegebenen Anzahl, vorzugsweise drei, Abtastwerten des zweiten Signals (s2) quadratisch interpoliert, die einem durch die vielfache Mittelungsabtastrate (L * fc) vorgegebenen Abtastzeitpunkt am nächsten liegen.

8. Abtastratenumsetzer nach Anspruch 7, **dadurch gekennzeichnet, dass** die zweite Interpolationseinrichtung (6) einen Multiplexer (10) und eine quadratische Interpolationseinheit (11) aufweist, wobei der Multiplexer (10) das zweite Signal (s2) aufnimmt und die drei dem vorgegebenen Abtastzeitpunkt am nächsten liegenden Abtastwerte an die quadratische Interpolationseinheit (11) weitergibt.

9. Abtastratenumsetzer nach Anspruch 8, **dadurch gekennzeichnet, dass** die Steuereinrichtung (4) ermittelt, ob in einem Abtastintervall des Eingangssignals (s1) ein Abtastwert des dritten Signals (s3) mit der vielfachen Mittelungsabtastrate (L * fc) zu berechnen ist, wobei die Steuereinrichtung (4) in dem Fall, dass ein Abtastwert des dritten Signals (s3) mit der vielfachen Mittelungsabtastrate (L * fc) zu berechnen ist, ein zweites Steuersignal (c2) das angibt welche Abtastwerte des zweiten Signals (s2) für die quadratische Interpolation verwendet werden an den Multiplexer (10) ausgibt und ein drittes Steuersignal (c3) mit einer für die quadratische Interpolation benötigten zeitlichen Position des Abtastzeitpunktes des dritten Signals (s3) mit der vielfachen Mittelungsabtastrate relativ zu den Abtastzeitpunkten der zur Interpolation verwendeten Abtastwerte des zweiten Signals (s2) an die quadratische Interpolationseinheit (11) ausgibt.

10. Abtastratenumsetzer nach einem der vorherigen Ansprüche, **dadurch gekennzeichnet, dass** der Zwischenspeicher ein Schieberegister (9) vorgegebener Länge (K) mit einer Überlauf-/Unter/-lauferkennung ist, das das Füllstandssignal (s6) ausgibt.

11. Abtastratenumsetzer nach einem der vorherigen Ansprüche, **dadurch gekennzeichnet, dass** die Einrichtung (14) zur Ermittlung einer mittleren Taktlänge aufweist eine Hardwarezähleinrichtung (15), die das Ausgangsfrequenzsignal (t_{z}) und das Eingangsfrequenzsignal (tₐ) aufnimmt und aus einem Vergleich mit einem Systemtakt (fsys) ermittelt, zwischen welchen Eingangsabtastzeitpunkt (Ta) des Eingangssignals ein Ausgangsabtastzeitpunkt (Tz) liegt, und ein Hardwarezählersignal (s7) ausgibt, eine Taktskalierungseinrichtung (16), die das Hardwarezählersignal (s7) aufnimmt, mit einem programmierbaren ersten Skalierungsfaktor (sc) gewichtet und ein skaliertes Zählersignal (s8) ausgibt und
eine zweite Tiefpasseinrichtung (17), die das skalierte Zählersignal (s8) aufnimmt, tiefpassfiltert und das mittlere Taktlängensignal (s10) ausgibt.

12. Abtastratenumsetzer nach Anspruch 2 oder nach Anspruch 2 und einem der Ansprüche 3 bis 11, **dadurch gekennzeichnet, dass** die Füllstandsskalierungseinrichtung (22) das Füllstandssignal (s6) aufnimmt, eine Differenz mit einem Soll-Füllstandssignal (s17) bildet, durch vorzugsweise mindestens eine Shiftoperation mit dem zweiten Faktor 2exp(L) skaliert, wobei L den ersten Faktor bezeichnet, mit einem Taktsignal (stakt) verknüpft, das angibt, in welcher Taktperiode des vielfachen Eingangsabtasttaktes relativ zum Eingangstakt ein Abtastwert des Ausgangssignals (s5) aus dem Zwischenspeicher (9) ausgelesen wurde, und anschließend durch mindestens eine weitere Shiftoperation das skalierte Füllstandssignal (s12) mit einer ersten Bitbreite (Bf) ausgegeben wird.

13. Abtastratenumsetzer nach einem der vorherigen Ansprüche, **dadurch gekennzeichnet, dass** die Gewichtungsberechnungseinrichtung (24) aus dem tiefpassgefilterten, skalierten Füllstandssignal (s13) durch eine Kennlinie das Korrektursignal (s14) bildet, wobei die Kennlinie einen konstanten Wert für Absolutwerte des tiefpassgefilterten, skalierten Füllstandssignals (s13) kleiner als ein erster Grenzwert und lineares oder affines für Absolutwerte des tiefpassgefilterten, skalierten Füllstandssignals (s13) größer als ein erster Grenzwert aufweist.

14. Abtastratenumsetzer nach einem der vorherigen Ansprüche, **dadurch gekennzeichnet, dass** die Gewichtungsberechnungseinrichtung (24) vom dem tiefpassgefilterten skalierten Füllstandssignal (s13) einen Absolutwert bildet, mit einem zweiten Skalierungsfaktor (2exp(Koef-P2)) zu einem ersten Hilfssignal (s21) gewichtet, aus einem Vergleich des ersten Hilfssignals (s21) und eines Vergleichswertes (Koef-P1) ein Maximalwertsignal (s22) ermittelt, und aus dem Maximalwertsignal (s22) und dem tiefpassgefilterten skalierten Füllstandssignal (s13) das Korrektursignal (s14) bildet, vorzugsweise durch eine Multiplikation, wobei der zweite Skalierungsfaktor (2exp(Koef-P2)) und der erste Vergleichswert (Koef-P1) programmierbar sind.

15. Abtastratenumsetzer nach Anspruch 11 oder Anspruch 11 und einem der Ansprüche 12 bis 14, **dadurch gekennzeichnet, gekennzeichnet, dass** die erste und zweite Tiefpasseinrichtung (17, 23) der Steuereinrichtung (4) jeweils Additionseinrichtungen (45, 48) und mindestens eine erste Shifteinrichtung (47) aufweisen und vorzugsweise frei von Multiplikationseinrichtungen sind.

16. Abtastratenumsetzer nach Anspruch 15, **dadurch gekennzeichnet, dass** die erste und zweite Tiefpasseinrichtung (17, 23) zum Tiefpassfiltern eines Eingabesignals (x) mit einer Eingabebitbreite (Bx) in ein Ausgabesignal (xm) jeweils einen ersten Addierer (45) aufweisen, in dem von dem Eingabesignal (x) das Ausgabesignal (xm) subtrahiert wird, von dem so gebildeten ersten Zwischensignal (x2) mit inkrementierter Eingabebitbreite ein Bit abgeschnitten wird, eine Skalierung um einen Skalierungswert (2exp(-N)) erfolgt, zu dem so gebitdeten zweiten Zwischensignal (x4) in einem zweiten Addierer (48) das Ausgabesignal (xm) addiert wird, von dem so gebildeten dritten Zwischensignal (x5) mit inkrementierter Eingabebitbreite ein Bit abgeschnitten wird und das so gebildete vierte Zwischensignal (x6) einen ersten Register (50) zugeführt wird, aus dem das Ausgabesignal (xm) ausgelesen wird.

17. Abtastratenumsetzer nach einem der vorherigen Ansprüche, **dadurch gekennzeichnet, dass** die Steuereinrichtung (4) eine dritten Addierer (20) aufweist, dem das mittlere Taktlängensignal (s10) über eine zweite Shifteinrichtung (19) und das Korrektursignal (s14) über eine dritte Shifteinrichtung (26) zugeführt wird, wobei der dritte Addierer (20) ein fünftes Zwischensignal (s16) einer Steuerbitbreite (B) an die Steuersignalberechnungseinrichtung (30) ausgibt.

18. Abtastratenumsetzer nach Anspruch 11 und Anspruch 17, **dadurch gekennzeichnet, dass** die Taktskalierungseinrichtung (16) das skalierte Zählersignal (s8) derartig bildet, dass eine Taktlänge des Eingangsabtasttaktes bei einer Darstellung mit der Steuerbitbreite (B) dem Wert 2 exp(B-2) entspricht, wobei B die Steuerbitbreite bezeichnet.

19. Abtastratenumsetzer nach Anspruch 9 und einem der Ansprüche 17, 18 **dadurch gekennzeichnet, dass** die Steuersignalberechnungseinrichtung (30) aus dem fünften Zwischensignal (s16) ein erstes Steuersignal (c1) mit einer zweiten Bitbreite von vorzugsweise zwei Bit zum Anzeigen, ob eine Interpolation durchzuführen ist, das zweite Steuersignal (c2) mit einer dritten Bitbreite von vorzugsweise zwei Bit zur Anzeige, welche Abtastwerte des zweiten Signals (s2) für die quadratische Interpolation zu verwenden sind und das dritte Steuersignal (c3) mit einer vierten Bitbreite von vorzugsweise fünfzehn Bit zur Angabe der Lage des Abtastzeitpunktes des Signals (s3) mit der vielfachen Mittelungsabtastrate (L*fc) relativ zu den Abtastzeitpunkten der zur quadratischen Interpolation verwendeten Abtastwerte des zweiten Signals (s2) mit der vielfachen Eingangsabtastrate (L*fa) erzeugt.

20. Abtastratenumsetzer nach Anspruch 19, **dadurch gekennzeichnet, dass** in der Steuersignalberechnungseinrichtung (30) das fünfte Zwischensignal (s16) in einem vierten Addierer (60) mit einem Gesamtsteuersignal (s28) addiert wird,
der Wert des so gebildeten zweiten Hilfssignals (s25) mit einem aus der Steuerbitbreite (B) gebildeten zweiten Vergleichswert (2exp(B-2)) verglichen wird,
in dem ersten Fall, dass der zweite Vergleichswert unterschritten wird, das zweite Hilfssignal (s25) einem fünften Addierer (62) zugeführt wird und in dem zweiten Fall, dass der zweite Vergleichswert nicht unterschritten wird, das Gesamtsteuersignal (s28) dem fünften Addierer (62) zugeführt wird,
in dem fünften Addierer (62) der aus der Steuerbitbreite (B) gebildete zweite Vergleichswert (2exp(B-2)) subtrahiert wird und einem zweiten Register (63) zugeführt wird, aus dem mit der Eingangsabtastrate (fa) das Gesamtsteuersignal (s28) mit der Steuerbitbreite (B) ausgelesen wird, das das erste, zweite und dritte Steuersignal (c1, c2, c3) umfasst.

21. Abtastratenumsetzer nach einem der vorherigen Ansprüche, **dadurch gekennzeichnet, dass** eine Auswertelogikeinrichtung (25) vorgesehen ist die aus dem Füllstandssignal (s6) ein Kontrollsignal (v) erzeugt, das den aktuellen Betriebszustand des Abtastratenumsetzers anzeigt, wobei das Kontrollsignal (v) den Betriebszustand "Unterlauf" anzeigt, wenn der Füllstand des Zwischenspeichers (9) kleiner/gleich einem zweiten Grenzwert (G1) ist und den Betriebszustand "Überlauf" anzeigt, wenn der Füllstand größer/gleich einem dritten Grenzwert (G2) ist.

22. Abtastratenumsetzer nach Anspruch 21, **dadurch gekennzeichnet, dass** der zweite Grenzwert (G1) auf 1 und der dritte Grenzwert (G2) auf den gegenüber der Zwischenspeichergröße (K) um 1 dekrementierten Wert (K - 1) gesetzt ist.

23. Abtastratenumsetzer nach Anspruch 21 oder 22, **dadurch gekennzeichnet, dass** die Auswertelogikeinrichtung (25) überprüft, ob in mehr als einer vorgegebenen Taktanzahl (Tv) von Taktperioden der Eingangsabtastrate (a) kein Taktsignal der Ausgangsabtastrate (fz) erkannt wird, und in diesem Fall in dem Kontrollsignal anzeigt, dass ein unzulässiger Ausgangstakt vorliegt.

## Claims

1. Sampling rate converter for conversion of an input signal (s1) at an input sampling rate (fa) to an output signal (s5) at an output sampling rate (fz), in particular for asynchronous input and output signals at an output sampling rate which varies over time, with the sampling rate converter having:
a first interpolation device (5) which receives the input signal (s1), carries out a first interpolation and emits a second signal (s2), whose sampling rate (L * fa) is a product of the input sampling rate (fa) and a first factor (L),
a second interpolation device (6), which receives the second signal (s2), carries out a second interpolation and emits a third signal (s3),
a decimation device (7), which receives the third signal (s3), carries out a decimation and emits a fourth signal (s4) at the average sampling rate (fc),
**characterized in that**
the second interpolation device (6) carries out the second interpolation as a function of at least one control signal (c1, 2, 3),
the third signal (s3) is at a multiple average sampling rate (L * fc) which is a product of an average sampling rate (fc) and the first factor (L),
the decimation device (7) carries out decimation by the first factor (L)
a control device (4) is provided which receives an input frequency signal (ta) and an output frequency signal (tz), determines the average sampling rate (fc) and emits the at least one control signal (c1, 2, 3) in order to set the second interpolation to the second interpolation device (6),
a buffer store (9) is provided, which receives the fourth signal (s4) and from which the output signal (s5) is read at the output sampling rate (fz),
with the buffer store (9) emitting a filling-level signal (s6) to the control device (4) as a function of its filling level, and the control device (4) controlling the filling level of the buffer store (9) by variation of the mean sampling rate (fc),
with the control device (4) having:
a device (14) for determination of a mean clock length, which receives the output frequency signal (tz) and emits a mean clock length signal (s10),
a device (21) for determination of a correction component, which receives the filling-level signal (s6) and emits a correction signal (s14), and
a control signal calculation device (30) which determines the at least one control signal (c1, 2, 3) as a function of the mean clock length signal (s10) and the correction signal (s14),
with the device (21) for determination of a correction component having a filling-level scaling device (22), which receives the filling-level signal (s6) and emits a scaled filling-level signal (s12), a first low-pass filter device (23), which low-pass filters the scaled filling-level signal (s12) and emits a low-pass-filtered, scaled filling-level signal (s13), and a weighting calculation device (24), which receives the low-pass-filtered, scaled filling-level signal (s13), weights it and emits the correction signal (s14).

2. Sampling rate converter according to Claim 1, **characterized in that** the first factor (L) is an integer.

3. Sampling rate converter according to Claim 2, **characterized in that** the first interpolation device (5) has one or more successive interpolation stages, in each of which oversampling of the input signal (s1) is carried out by insertion of integer numbers of zeros between two input values, and subsequent low-pass filtering.

4. Sampling rate converter according to Claim 3, **characterized in that** the low-pass filters in the interpolation stages of the first interpolation device (5) are FIR filters, preferably with symmetrical coefficients.

5. Sampling rate converter according to one of the preceding claims, **characterized in that** the decimation device (7) low-pass-filters the third signal (s3) and then undersamples it, preferably by means of a polyphase filter, which determines the sample values required for the undersampling of the fourth signal (s4) at the average sampling rate (fc).

6. Sampling rate converter according to one of the preceding claims, **characterized in that** the second interpolation device (6) carries out a non-linear, preferably quadratic interpolation, using the sample values of the second signal (s2), as a function of the control signal (c1, 2, 3).

7. Sampling rate converter according to Claim 6, **characterized in that** the second interpolation device (6) determines the sample values of the third signal (s3) by quadratic interpolation between a predetermined number of, preferably three, sample values of the second signal (s2), which are closest to a sampling time which is predetermined by the multiple average sampling rate (L * fc).

8. Sampling rate converter according to Claim 7, **characterized in that** the second interpolation device (6) has a multiplexer (10) and a quadratic interpolation unit (11), with the multiplexer (10) receiving the second signal (s2) and passing on to the quadratic interpolation unit (11) the three sample values which are closest to the predetermined sampling time.

9. Sampling rate converter according to Claim 8, **characterized in that** the control device (4) determines whether a sample value of the third signal (s3) at the multiple average sampling rate (L * fc) should be calculated in a sampling interval of the input signal (s1),
with the control device (4) emitting to the multiplexer (10) a second control signal (c2) which indicates which sample values of the second signal (s2) are used for the quadratic interpolation in the situation in which a sample value of the third signal (s3) at the average sampling rate (L * fc) should be calculated, and emitting a third control signal (c3) to the quadratic interpolation unit (11) at a time (as required for the quadratic interpolation) of the sampling time of the third signal (s3) at the multiple average sampling rate relative to the sampling times for the sample values of the second signal (s2) which are used for interpolation.

10. Sampling rate converter according to one of the preceding claims, **characterized in that** the buffer store is a shift register (9) of predetermined length (K) with an overflow/underflow identification, which emits the filling-level signal (s6).

11. Sampling rate converter according to one of the preceding claims, **characterized in that** the device (14) for determination of a mean clock length has a hardware counting device (15), which receives the output frequency signal (tz) and the input frequency signal (ta) and determines from a comparison with a system clock (fsys) the input sampling times (Ta) of the input signal between which an output sampling time (Tz) is located, and emits a hardware counter signal (s7),
a clock scaling device (16), which receives the hardware counter signal (s7), weights it with a first programmable scaling factor (sc) and emits a scaled counter signal (s8), and
a second low-pass filter device (17), which receives the scaled counter signal (s8), low-pass filters it and emits the mean clock length signal (s10).

12. Sampling rate converter according to one of the preceding claims, **characterized in that** the filling-level scaling device (22) receives the filling-level signal (s6), forms a difference between it and a nominal filling-level signal (s17), scales this with the second factor 2exp(L), preferably by means of at least one shift operation, in which case L denotes the first factor, links this with a clock signal (stakt) which indicates the clock period of the multiple input sampling clock relative to the input clock in which a sample value of the output signal (s5) is read from the buffer store (9), and the scaled filling-level signal (s12) is subsequently emitted with a first bit length (Bf) by means of at least one further shift operation.

13. Sampling rate converter according to one of the preceding claims, **characterized in that** the weighting calculation device (24) forms the correction signal (s14) by means of a characteristic from the low-pass-filtered, scaled filling-level signal (s13), with the characteristic having a constant value for absolute values of the low-pass-filtered, scaled filling-level signal (s13) which are less than a first limit value, and a linear or affine value for absolute values of the low-pass-filtered, scaled filling-level signal (s13) which is greater than a first limit value.

14. Sampling rate converter according to one of the preceding claims, **characterized in that** the weighting calculation device (24) forms an absolute value from the low-pass-filtered, scaled filling-level signal (s13), weights this with a second scaling factor (2exp(Coef-P2)) to form a first auxiliary signal (s21), determines a maximum value signal (s22) from a comparison of the first auxiliary signal (s21) and a comparison value (Coef-P1), and forms the correction signal (s14) from the maximum value signal (s22) and the low-pass-filtered scaled filling-level signal (s13), preferably by means of a multiplication operation, with the second scaling factor (2exp(Coef-P2)) and the first comparison value (Coef-P1) being programmable.

15. Sampling rate converter according to Claim 11, or Claim 11 and one of Claims 12 to 14, **characterized in that** the first and second low-pass filter devices (17, 23) of the control device (4) have respective addition devices (45, 48) and at least one first shift device (47), and are preferably free of multiplication devices.

16. Sampling rate converter according to Claim 15, **characterized in that** the first and second low-pass filter devices (17, 23) each have a first adder (45) for low-pass filtering of an input signal (x) with an input bit length (Bx) to form an output signal (xm), in which the output signal (xm) is subtracted from the input signal (x), one bit is cut off from the first intermediate signal (x2) formed in this way with the incremented input bit length, scaling is carried out by a scaling factor (2exp(-N)), the output signal (xm) is added to the second intermediate signal (x4) formed in this way in a second adder (48), one bit is cut off from the third intermediate signal (x5) formed in this way with the incremented input bit length, and the fourth intermediate signal (x6) formed in this way is supplied to a first register (50), from which the output signal (xm) is read.

17. Sampling rate converter according to one of the preceding claims, **characterized in that** the control device has a third adder (20), to which the mean clock length signal (s10) is supplied via a second shift device (19), and the correction signal (s14) is supplied via a third shift device (26), with the third adder (20) emitting a fifth intermediate signal (s16) with a control bit length (B) to the control signal calculation device (30).

18. Sampling rate converter according to Claim 11 and Claim 17, **characterized in that** the clock scaling device (16) forms the scaled counter signal (s8) in such a way that a clock length of the input sampling clock corresponds to the value 2exp(B-2), where B denotes the control bit length, in representation with the control bit length (B).

19. Sampling rate converter according to Claim 9 and one of Claims 17, 18, **characterized in that** the control signal calculation device (30) uses the fifth intermediate signal (s16) to produce a first control signal (c1) with a second bit length of preferably two bits in order to indicate whether interpolation should be carried out, the second control signal (c2) with a third bit length of preferably two bits in order to indicate which sample values of the second signal (s2) should be used for the quadratic interpolation, and the third control signal (c3) with a fourth bit length of preferably fifteen bits in order to indicate the location of the sampling time of the signal (s3) at the multiple average sampling rate (L * fc) relative to the sampling times of the sample values of the second signal (s2) which are used for the quadratic interpolation, with the signal (s2) being at the multiple input sampling rate (L * fa).

20. Sampling rate converter according to Claim 19, **characterized in that** the fourth intermediate signal (s16) is added in a fifth adder (60) to an overall control signal (s28) in the control signal calculation device (30),
the value of the second auxiliary signal (s25) formed in this way is compared with a second comparison value (2exp(B-2)) formed from the control bit length (B),
in the first case, in which the second comparison value is undershot, the second auxiliary signal (s25) is supplied to a fifth adder (62), and in the second case, in which the second comparison value is not undershot, the overall control signal (s28) is supplied to the fifth adder (62),
the second comparison value (2exp(B-2)), which is formed from the control bit length (B), is subtracted in the fifth adder (62) and is supplied to a second register (63), from which the overall control signal (s28) is read at the input sampling rate (fa), and with the control bit length (B), and comprises the first, second and third control signals (c1, c2, c3).

21. Sampling rate converter according to one of the preceding claims, **characterized in that** an evaluation logic device (25) is provided and produces a monitoring signal (v) from the filling-level signal (s6), which monitoring signal (v) indicates the current operating state of the sampling rate converter, with the monitoring signal (v) indicating the "underflow" operating state when the filling level of the buffer store (9) is less than or equal to a second limit value (G1), and indicating the "overflow" operating state when the filling level is greater than or equal to a third limit value (G2).

22. Sampling rate converter according to Claim 21, **characterized in that** the second limit value (G1) is set to 1, and the third limit value (G2) is set to the value (K - 1), decremented by 1 from the buffer store variable (K).

23. Sampling rate converter according to Claim 21 or 22, **characterized in that** the evaluation logic device (25) checks whether no clock signal at the output sampling rate (fz) is identified in more than one predetermined number of clock cycles (Tv) of clock periods of the input sampling rate (fa) and in this case indicates in the monitoring signal that the output clock rate is not permissible.

## Revendications

1. Convertisseur de fréquence d'échantillonnage pour convertir un signal d'entrée (s1) avec une fréquence d'échantillonnage d'entrée (fa), en un signal de sortie (s5) avec une fréquence d'échantillonnage de sortie (fz), en particulier pour des signaux d'entrée et de sortie non synchrones avec une fréquence d'échantillonnage de sortie variable dans le temps, le convertisseur de fréquence d'échantillonnage présentant :
un premier dispositif d'interpolation (5) qui reçoit le signal d'entrée (s1), exécute une première interpolation et émet un deuxième signal (s2) dont la fréquence d'échantillonnage (L*fa) est un produit de la fréquence d'échantillonnage d'entrée (fa) et d'un premier facteur (L),
un deuxième dispositif d'interpolation (6) qui reçoit le deuxième signal (s2), exécute une deuxième interpolation et émet un troisième signal (S3),
un dispositif de décimation (7) qui reçoit le troisième signal (S3), exécute une décimation et émet un quatrième signal (s4) avec la fréquence d'échantillonnage moyenne (fc),
**caractérisé en ce que**
le deuxième dispositif d'interpolation (6) exécute la deuxième interpolation en fonction d'au moins un signal de commande (c 1, 2, 3),
le troisième signal (s3) présente une fréquence d'échantillonnage moyenne multiple (L*fc) qui est un produit d'une fréquence d'échantillonnage moyenne (fc) et du premier facteur (L),
le dispositif de décimation (7) exécute une décimation du premier facteur (L),
un dispositif de commande (4) reçoit un signal de fréquence d'entrée (ta) et un signal de fréquence de sortie (tz), il détermine la fréquence d'échantillonnage moyenne (fc) et émet l'au moins un signal de commande (c 1, 2, 3) pour régler la deuxième interpolation vers le deuxième dispositif d'interpolation (6),
une mémoire intermédiaire (9), de laquelle est extrait le signal de sortie (s5) avec la fréquence d'échantillonnage de sortie (fz), reçoit le quatrième signal (s4),
la mémoire intermédiaire (9) émettant vers le dispositif de commande (4) un signal de niveau (s6) en fonction de son degré de charge et le dispositif de commande (4) régule le degré de charge de la mémoire intermédiaire (9) en modifiant la fréquence d'échantillonnage moyenne (fc),
le dispositif de commande (4) présentant
un dispositif (14) qui reçoit le signal de fréquence de sortie (tz) et émet un signal moyen de longueur d'horloge moyenne (s10), pour déterminer une longueur d'horloge moyenne reçue,
un dispositif (21) qui reçoit le signal de niveau (s6) et émet un signal de correction (s14) pour déterminer une partie de correction, et
un dispositif de calcul de signal de commande (30) qui détermine l'au moins un signal de commande (c, 1, 2, 3) en fonction du signal de longueur d'horloge moyenne (s10) et du signal de correction (s14),
le dispositif (21) pour déterminer une partie de correction présentant
un dispositif de cadrage de niveau (22) qui reçoit le signal de niveau (s6) et émet un signal de niveau cadré (s12),
un premier dispositif passe-bas (23) qui filtre passe-bas le signal de niveau cadré (s12) et émet un signal de niveau cadré filtré passe-bas (s13), et
un dispositif de calcul de pondération (24) qui reçoit le signal de niveau (s13) filtré passe-bas et cadré, l'évalue et émet le signal de correction (s14).

2. Convertisseur de fréquence d'échantillonnage selon la revendication 1,
**caractérisé en ce que**
le premier facteur (L) est un nombre entier.

3. Convertisseur de fréquence d'échantillonnage selon la revendication 2,
**caractérisé en ce que**
le premier dispositif d'interpolation (5) présente un ou plusieurs niveaux d'interpolation successifs où sont effectués respectivement un suréchantillonnage du signal d'entrée (s1) en insérant des nombres entiers de zéros entre deux valeurs d'entrée et un filtrage passe-bas suivant.

4. Convertisseur de fréquence d'échantillonnage selon la revendication 3,
**caractérisé en ce que**
les filtres passe-bas des niveaux d'interpolation du premier dispositif d'interpolation (5) sont des filtres FIR, de préférence avec des coefficients symétriques.

5. Convertisseur de fréquence d'échantillonnage selon l'une des revendications précédentes,
**caractérisé en ce que**
le dispositif de décimation (7) filtre passe-bas le troisième signal (s3) puis le souséchantillonne ensuite, de préférence au moyen d'un filtre polyphasé qui détermine les valeurs d'échantillonnage du quatrième signal (s4) nécessaire pour le sous-échantillonnage avec la fréquence d'échantillonnage moyenne (fc).

6. Convertisseur de fréquence d'échantillonnage selon l'une des revendications précédentes,
**caractérisé en ce que**
le deuxième dispositif d'interpolation (6) effectue une interpolation non linéaire, de préférence carrée avec les valeurs d'échantillonnage du deuxième signal (s2) en fonction du signal de commande (c 1, 2, 3).

7. Convertisseur de fréquence d'échantillonnage selon la revendication 6,
**caractérisé en ce que**
le deuxième dispositif d'interpolation (6) détermine les valeurs d'échantillonnage du troisième signal (s3) par interpolation carrée entre un nombre prédéfini de valeurs d'échantillonnage, de préférence trois, du deuxième signal (s2) qui se situent au plus près du moment d'échantillonnage prédéfini par la fréquence d'échantillonnage moyenne multiple (L*fc).

8. Convertisseur de fréquence d'échantillonnage selon la revendication 7,
**caractérisé en ce que**
le deuxième dispositif d'interpolation (6) présente un multiplexeur (10) et une unité d'interpolation carrée (11), le multiplexeur (10) recevant le deuxième signal (s2) et transmettant à l'unité d'interpolation carrée (11) les trois valeurs d'échantillonnage situées au plus près du moment d'échantillonnage prédéfini.

9. Convertisseur de fréquence d'échantillonnage selon la revendication 8,
**caractérisé en ce que**
le dispositif de commande (4) détermine si, dans un intervalle d'échantillonnage du signal d'entrée (s1), il faut calculer une valeur d'échantillonnage du troisième signal (s3) avec la fréquence d'échantillonnage moyenne multiple (L*fc),
le dispositif de commande (4), au cas où il faut calculer une valeur d'échantillonnage du troisième signal (s3) avec la fréquence d'échantillonnage moyenne multiple (L*fc), émettant vers le multiplexeur (10) un deuxième signal de commande (c2), qui indique quelles valeurs d'échantillonnage du deuxième signal (s2) sont utilisées pour l'interpolation carrée, et émettant vers l'unité d'interpolation carrée (11) un troisième signal de commande (c3) avec une position dans le temps du moment d'échantillonnage, nécessaire pour l'interpolation carrée, du troisième signal (s3) avec la fréquence d'échantillonnage moyenne multiple, par rapport aux moments d'échantillonnage des valeurs d'échantillonnage du deuxième signal (s2) utilisées pour l'interpolation.

10. Convertisseur de fréquence d'échantillonnage selon l'une des revendications précédentes,
**caractérisé en ce que**
la mémoire intermédiaire est un registre à décalage (9) d'une longueur (K) prédéfinie avec identification de dépassement positif/négatif qui émet le signal de niveau (s6).

11. Convertisseur de fréquence d'échantillonnage selon l'une des revendications précédentes,
**caractérisé en ce que**
le dispositif (14) pour déterminer une longueur d'horloge moyenne présente un dispositif de comptage matériel (15) qui reçoit le signal de fréquence de sortie (tz) et le signal de fréquence d'entrée (ta) et détermine à partir d'une comparaison avec une horloge du système (fsys) entre quels moments d'échantillonnage d'entrée (Ta) du signal d'entrée se situe un moment d'échantillonnage de sortie (Tz), et émet un signal de compteur matériel (s7),
un dispositif de cadrage d'horloge (16) qui reçoit le signal de compteur matériel (s7), l'évalue avec un premier facteur de cadrage (sc) programmable et émet un signal de compteur cadré (s8), et
un deuxième dispositif passe-bas (17) qui reçoit le signal de compteur cadré (s8), le filtre passe-bas et émet le signal de longueur d'horloge moyenne (s10).

12. Convertisseur de fréquence d'échantillonnage selon la revendication 2 ou selon la revendication 2 et l'une des revendications 3 à 11,
**caractérisé en ce que**
le dispositif de cadrage de niveau (22) reçoit le signal de niveau (s6), forme une différence avec un signal de niveau de consigne (s17), la cadre de préférence par au moins une opération de décalage avec le deuxième facteur 2exp(L), L désignant le premier facteur, la combine avec un signal d'horloge (stakt) qui indique dans quelle période d'horloge de la cadence d'horloge d'échantillonnage d'entrée par rapport à la cadence d'horloge d'entrée une valeur d'échantillonnage du signal de sortie (s5) a été extraite de la mémoire intermédiaire (9), puis émet par au moins une autre opération de décalage le signal de niveau cadré (s 12) avec une première largeur de bit (Bf).

13. Convertisseur de fréquence d'échantillonnage selon l'une des revendications précédentes,
**caractérisé en ce que**
le dispositif de calcul de pondération (24) forme à partir du signal de niveau (s13) cadré filtré passe-bas le signal de correction (s 14) par une ligne caractéristique, la ligne caractéristique présentant une valeur constante pour des valeurs absolues du signal de niveau cadré filtré passe-bas (s13) inférieure à une première valeur limite et une valeur linéaire ou affinée pour des valeurs absolues du signal de niveau cadré filtré passe-bas (s 13) supérieure à une première valeur limite.

14. Convertisseur de fréquence d'échantillonnage selon l'une des revendications précédentes,
**caractérisé en ce que**
le dispositif de calcul de pondération (24) forme une valeur absolue à partir du signal de niveau cadré filtré passe-bas (s13), l'évalue avec un deuxième facteur de cadrage (2exp(Koef-P2)) pour obtenir un premier signal auxiliaire (s21), détermine un signal de valeur maximale (s22) à partir d'une comparaison entre le premier signal auxiliaire (s21) et une valeur de comparaison (Koef-P1), et forme, de préférence par une multiplication, le signal de correction (s14) à partir du signal de valeur maximale (s22) et du signal de niveau cadré filtré passe-bas (s13), le deuxième facteur de cadrage (2exp(Koef-P2)) et la première valeur de comparaison (Koef-P1) étant programmables.

15. Convertisseur de fréquence d'échantillonnage selon la revendication 11 ou selon la revendication 11 et l'une quelconque des revendications 12 à 14,
**caractérisé en ce que**
le premier et le deuxième dispositifs passe-bas (17, 23) du dispositif de commande (4) présentent chacun des dispositifs d'addition (45, 48) et au moins un premier dispositif de décalage (47) et ne présentent de préférence pas de dispositifs de multiplication.

16. Convertisseur de fréquence d'échantillonnage selon la revendication 15,
**caractérisé en ce que**
pour le filtrage passe-bas d'un signal de saisie (x) d'une largeur de bit de saisie (Bx) en un signal d'émission (xm), le premier et le deuxième dispositifs passe-bas (17, 23) présentent chacun un premier additionneur (45), dans lequel le signal d'émission (xm) est soustrait du signal de saisie (x), du premier signal intermédiaire (x2) ainsi formé, un bit est coupé avec une largeur de bit de saisie incrémentée, un cadrage d'une valeur de cadrage (2exp(-N)) est effectué, au deuxième signal intermédiaire (x4) ainsi formé le signal d'émission (xm) est additionné dans un deuxième additionneur (48), du troisième signal intermédiaire (x5) ainsi formé, un bit est coupé avec une largueur de bit de saisie incrémentée, et le quatrième signal intermédiaire (x6) ainsi formé est transmis à un premier registre (50) duquel est extrait le signal d'émission (xm).

17. Convertisseur de fréquence d'échantillonnage selon l'une des revendications précédentes,
**caractérisé en ce que**
le dispositif de commande (4) présente un troisième additionneur (20) auquel sont transmis le signal de longueur d'horloge moyenne (s10) par l'intermédiaire d'un deuxième dispositif de décalage (19) et le signal de correction (s14) par l'intermédiaire d'un troisième dispositif de décalage (26), le troisième additionneur (20) émettant un cinquième signal intermédiaire (s 16) d'une largeur de bit de commande (B) vers le dispositif de calcul de signal de commande (30).

18. Convertisseur de fréquence d'échantillonnage selon les revendications 11 et 17,
**caractérisé en ce que**
le dispositif de cadrage d'horloge (16) forme le signal de compteur cadré (s8) de telle sorte qu'une longueur d'horloge de la cadence d'horloge d'échantillonnage d'entrée, dans une représentation avec la largeur de bit de commande (B), correspond à la valeur de 2exp(B-2), B désignant la largeur de bit de commande.

19. Convertisseur de fréquence d'échantillonnage selon la revendication 9 et l'une des revendications 17, 18,
**caractérisé en ce que**
le dispositif de calcul de signal de commande (30) génère à partir du cinquième signal intermédiaire (s 16) un premier signal de commande (c1) avec une deuxième largeur de bit, de préférence de deux bits, pour indiquer s'il faut effectuer une interpolation, le deuxième signal de commande (c2) avec une troisième largeur de bit, de préférence de deux bits, pour indiquer quelles valeurs d'échantillonnage du deuxième signal (s2) sont à utiliser pour l'interpolation carrée, et le troisième signal de commande (c3) avec une quatrième largeur de bit, de préférence de quinze bits, pour indiquer la position du moment d'échantillonnage du signal (s3) avec la fréquence d'échantillonnage moyenne multiple (L*fc) par rapport aux moments d'échantillonnage des valeurs d'échantillonnage du deuxième signal (s2) utilisées pour l'interpolation carrée avec la fréquence d'échantillonnage d'entrée (L*fa).

20. Convertisseur de fréquence d'échantillonnage selon la revendication 19,
**caractérisé en ce que**
dans le dispositif de calcul de signal de commande (30)
le cinquième signal intermédiaire (s 16) est additionné dans un quatrième additionneur (60) avec un signal de commande total (s28),
la valeur du deuxième signal auxiliaire (s25) ainsi formé est comparée avec une deuxième valeur de comparaison (2exp(B-2)) formée à partir de la largeur de bit de commande (B),
dans le premier cas, où la deuxième valeur de comparaison n'est pas atteinte, le deuxième signal auxiliaire (s25) est transmis à un cinquième additionneur (62), et dans le deuxième cas, où la deuxième valeur de comparaison est atteinte, le signal de commande total (s28) est transmis au cinquième additionneur (62),
dans le cinquième additionneur (62) la deuxième valeur de comparaison (2exp(B-2)) formée à partir de la largeur de bit de commande (B) est soustraite et transmise à un deuxième registre (63) duquel est extrait avec la fréquence d'échantillonnage d'entrée (fa) le signal de commande total (s28) avec la largeur de bit de commande (B), qui comprend le premier, le deuxième et le troisième signal de commande (c1, c2, c3).

21. Convertisseur de fréquence d'échantillonnage selon l'une des revendications précédentes,
**caractérisé en ce qu'**
un dispositif logique d'exploitation (25) est prévu, qui génère à partir du signal de niveau (s6) un signal de contrôle (v) qui indique l'état de fonctionnement actuel du convertisseur de fréquence d'échantillonnage, le signal de contrôle (v) indiquant l'état de fonctionnement « dépassement négatif » si le niveau de la mémoire intermédiaire (9) est inférieur/égal à une deuxième valeur limite (G1), et l'état de fonctionnement « dépassement positif » si le niveau est supérieur/égal à une troisième valeur limite (G2).

22. Convertisseur de fréquence d'échantillonnage selon la revendication 21,
**caractérisé en ce que**
la deuxième valeur limite (G1) est placée à 1 et la troisième valeur limitée (G2) est placée à la valeur (K - 1) décrémentée de 1 par rapport à la grandeur de mémoire intermédiaire (K).

23. Convertisseur de fréquence d'échantillonnage selon les revendications 21 ou 22,
**caractérisé en ce que**
le dispositif logique d'exploitation (25) vérifie si, dans un plus grand nombre de cadences d'horloge (Tv) que prédéfini des périodes d'horloge de la fréquence d'échantillonnage d'entrée (fa) aucun signal d'horloge de la fréquence d'échantillonnage de sortie (fz) n'est détecté, et indique dans ce cas dans le signal de contrôle la présence d'une cadence d'horloge inadmissible.
